# EUROPEAN PATENT APPLICATION

(11) **EP 2 066 156 A2**
(43) Date of publication of application: **03.06.2009**
(21) Application number: 08169709.6
(22) Date of filing: 21.11.2008
(51) Int. Cl.: H05K 1/02

(54) **Wiring substrate and method of manufacturing the same**

(30) Priority: 21.11.2007 JP 2007302007
(71) Applicant: Shinko Electric Industries Co., Ltd., Nagano-shi, Nagano 381-2287 (JP)
(72) Inventor: Kurihara, Takashi, Shinko Electric Industries co., Ltd., Nagano 381-2287 (JP); Murayam, Kei, Shinko Electric Industries co., Ltd., Nagano 381-2287 (JP)
(74) Representative: Zimmermann & Partner

(57) **Abstract**

There is provided a wiring substrate 1A. The wiring substrate 1A includes a wiring member 30 and a reinforcing layer 50. The wiring member 30 is formed by layering insulating layers and wiring layers and has connection pads 18 thereon. The reinforcing layer 50 is provided on the wiring member 30 to surround the connection pads 18 and has a plurality of concave-convex portions 50a thereon.

## Description

Apparatuses and devices consistent with the present invention relates to a wiring substrate and methods of manufacturing the same and, more particularly, to a wiring substrate including a reinforcing member and a method of manufacturing the same. Further, the present disclosure also relates to a semiconductor device.

As the method of manufacturing the wiring substrate on which an electronic component is mounted, there is a method of manufacturing the wiring substrate by forming wiring layers on a supporting body and then separating the wiring layers from the supporting body. In this method, since the supporting body exists when the build-up wiring layer is formed, the build-up wiring layer can be formed without fail with good precision.

However, in the wiring substrate from which the supporting body is removed completely, a mechanical strength of the substrate itself is weak. As a consequence, for example, when a heat is applied in mounting a semiconductor chip on the wiring substrate (primary mounting) and in mounting the wiring substrate on which the semiconductor chip is mounted on a mother board (secondary mounting), the wiring substrate is easily deformed.

International Publication No. WO2003/039219 describes a wiring substrate that addresses the above problem. FIG.1 shows the wiring substrate disclosed in WO2003/039219. As shown in FIG.1, a semiconductor element mounting surface is formed by removing a center portion of a copper plate 105. The copper plate 105 acts as a supporting body of a wiring member 103 in which insulating layers 102 and wiring layers 101 are repeatedly formed. Also, the remaining copper plate 105 is used as a reinforcing plate of a multilayer circuit substrate 100, so that strength of the wiring substrate can be ensured.

However, since the reinforcing plate constructed as above is formed of the copper plate 105 acting as the supporting body, the reinforcing plate is thick and its weight is heavy. Also, the reinforcing plate is provided uniformly to the frame portion that surrounds the semiconductor element mounting surface. Therefore, this approach cannot effectively address the deformation of the wiring substrate.

Exemplary embodiments of the present invention address the above disadvantages and other disadvantages not described above. However, the present invention is not required to overcome the disadvantages described above, and thus, an exemplary embodiment of the present invention may not overcome any of the problems described above.
At least some of the problems in the art are overcome by the wiring substrate according to claim 1, the semiconductor device according to claim 4 and the methods for manufacturing a wiring substrate according to claims 5 and 6. Further aspects, details and advantages are evident from the dependent claims, the description and the accompanying drawings.

Accordingly, it is an aspect of the present invention to provide a wiring substrate capable of improving a mechanical strength while achieving a reduction in weight and a method of manufacturing the same.

According to one aspect of the present disclosure, there is provided a wiring substrate. The wiring substrate including: a wiring member formed by at least one layering insulating layer and at least one wiring layer, the wiring member including at least one connection pad thereon; and a reinforcing layer which is provided on the wiring member to surround the at least one connection pad and which comprises a plurality of concave-convex portions thereon.
According to one or more aspects of the present invention, there is provided a wiring substrate. The wiring substrate includes: a wiring member formed by layering insulating layers and wiring layers, the wiring member comprising connection pads thereon; and a reinforcing layer which is provided on the wiring member to surround the connection pads and which comprises a plurality of concave-convex portions thereon.

According to one or more aspects of the present invention, the concave-convex portions are provided to extend in plural different directions.

According to one or more aspects of the present invention, the reinforcing layer is formed of copper, and, preferably, a nickel layer is provided on convex top end portions of the concave-convex portions.

According to one or more aspects of the present invention, there is provided a semiconductor device. The semiconductor device includes: the wiring substrate; a semiconductor element mounted on the wiring substrate; and a heat spreader provided on the semiconductor element.

According to another aspect of the present disclosure, there is provided a method of manufacturing a wiring substrate. The method includes: (a) layering at least one insulating layer and at least one wiring layer on a supporting body to form a wiring member; (b) removing a part of the supporting body from the wiring member to form an opening through which an outermost surface of the at least one wiring layer is exposed; and (c) patterning a reinforcing layer to form a plurality of concave-convex portions in the reinforcing layer.
According to one or more aspects of the present invention, there is provided a method of manufacturing a wiring substrate. The method includes: (a) layering insulating layers and wiring layers on a supporting body to form a wiring member; (b) removing a part of the supporting body from the wiring member to form an opening through which outermost surfaces of the wiring layers are exposed; and (c) patterning the reinforcing layer to form a plurality of concave-convex portions in the reinforcing layer.

According to another aspect of the present disclosure, there is provided a method of manufacturing a wiring substrate. The method includes: (a) layering at least one insulating layer and at least one wiring layer on a supporting body to form a wiring member; (b) removing the supporting body from the wiring member; and (c) providing a reinforcing layer having a plurality of concave-convex portions thereon on the wiring member via an adhesive.
According to one or more aspects of the present invention, there is provided a method of manufacturing a wiring substrate. The method includes: (a) layering insulating layers and wiring layers on a supporting body to form a wiring member; (b) removing the supporting body from the wiring member; and (c) providing a reinforcing layer having a plurality of concave-convex portions thereon on the wiring member via an adhesive.

According to the present invention, a concave-convex shape is provided to the reinforcing layer. Therefore, a mechanical strength can be improved as compared with the structure in the related art, while achieving a reduction in weight of the wiring substrate to which the reinforcing layer is provided.
Thus, according to the present disclosure, there is provided a wiring substrate. The wiring substrate includes a wiring member and a reinforcing layer. The wiring member is formed by layering insulating layers and wiring layers and has connection pads thereon. The reinforcing layer is provided on the wiring member to surround the connection pads and has a plurality of concave-convex portions thereon.
The present disclosure is also directed to an apparatus for carrying out the disclosed methods and including apparatus parts for performing each described method steps. These method steps may be performed by way of hardware components, a computer programmed by appropriate software, by any combination of the two or in any other manner. Furthermore, the invention is also directed to methods by which the described apparatus operates. It includes method steps for carrying out every function of the apparatus.

Embodiments of the present disclosure will be described with respect to the accompanying drawings in more detail in the following. Other aspects and advantages of the present invention will be apparent from the following description, the drawings, and the claims.

The above and other aspects, features and advantages of the present invention will be more apparent from the following more particular description thereof, presented in conjunction with the following drawings wherein:

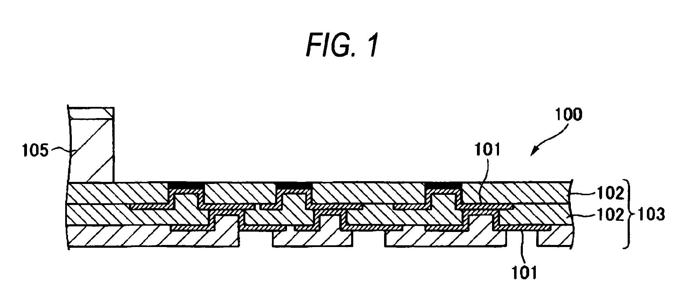

FIG.1 is a view showing a wiring substrate in the related art;
FIGS.2A and 2B are views showing a structure in which a semiconductor element is mounted on a wiring substrate 1A according to a first embodiment of the present invention, where FIG.2A shows a cross-sectional view of the structure and FIG.2B shows a plan view of the structure;
FIGS.3A to 3E are cross-sectional views showing a variation of a concave-convex strip portion 50a according to the first embodiment of the present invention;
FIGS.4A to 4H are plan views showing a variation of the concave-convex strip portion 50a according to the first embodiment of the present invention;
FIG.5 is a sectional view showing a structure in which a semiconductor element is mounted on the wiring layer 18C side, in accordance with a modified embodiment of the present invention;
FIGS.6A to 6D are sectional views (#1) showing a method of manufacturing the wiring substrate 1A according to the first embodiment of the present invention;
FIGS.7A to 7D are sectional views (#2) showing the method of manufacturing the wiring substrate 1A according to the first embodiment of the present invention;
FIGS.8A to 8C are sectional views (#3) showing the method of manufacturing the wiring substrate 1A according to the first embodiment of the present invention;
FIG.8D is a sectional view showing the concave-convex portions 50a according to the first embodiment of the present invention;
FIG.9A is a sectional view showing a wiring substrate 1C according to a second embodiment of the present invention;
FIGS.9B and 9C are sectional views showing a variation of the wiring substrate 1C according to the second embodiment;
FIGS.10A and 10B are sectional views showing a method of manufacturing the wiring substrate 1C according to the second embodiment of the present invention;
FIG.11A is a sectional view showing a wiring substrate 1F according to a third embodiment of the present invention;
FIG.11B is a sectional view showing a state that a semiconductor element and a heat spreader are mounted on the wiring substrate 1F according to the third embodiment of the present invention;
FIG.11C is a sectional view showing a structure in which a semiconductor element is mounted on the wiring layer 18C side, in accordance with a modified embodiment of the third embodiment; and
FIGS.12A to 12E are sectional views showing a method of manufacturing the wiring substrate 1F according to the third embodiment of the present invention.

Exemplary embodiments of the present invention will be described with reference to the drawings hereinafter.

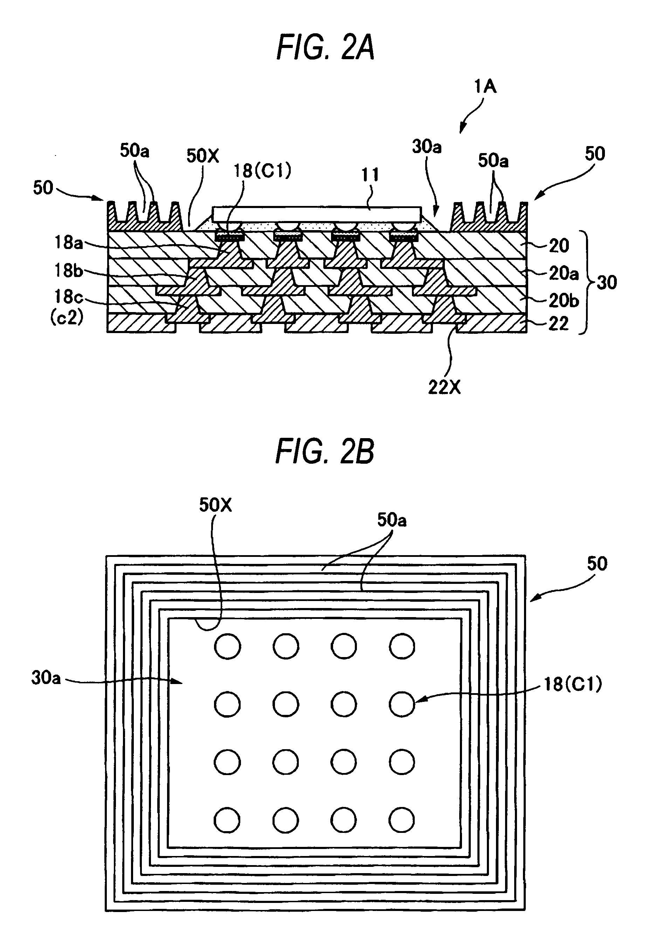

FIGS.2A and 2B show a structure in which a semiconductor element is mounted on a wiring substrate 1A according to a first embodiment of the present invention. FIG.2A is a cross-sectional view of the wiring substrate 1A on which the semiconductor element is mounted and FIG.2B is a plan view of the wiring substrate 1A.

The wiring substrate 1A according to the present embodiment, if classified roughly, is constructed by a wiring member 30 and a reinforcing layer 50. The wiring member 30 is formed by layering insulating layers 20, 20a, 20b, and wiring layers 18, 18a, 18b, 18c.

The first wiring layers 18 serving as first connection terminals C1 (in the explanation, sometimes called connection pads 18) are exposed from a surface 30a of the wiring member 30. Also, a solder resist 22 is formed on the back surface of the wiring member 30, and opening portions 22X are provided in the solder resist 22. Each of the fourth wiring layers 18c serving as a second connection terminal C2 is exposed from the opening portions 22X.

The reinforcing layer 50 acts as a reinforcing member (stiffener) of the wiring member 30. As shown in FIG.2B, an opening portion 50X is formed in the center portion of the reinforcing layer 50, and surfaces of the first wiring layers 18 on the surface 30a of the wiring member 30 are exposed from the opening portion 50X.

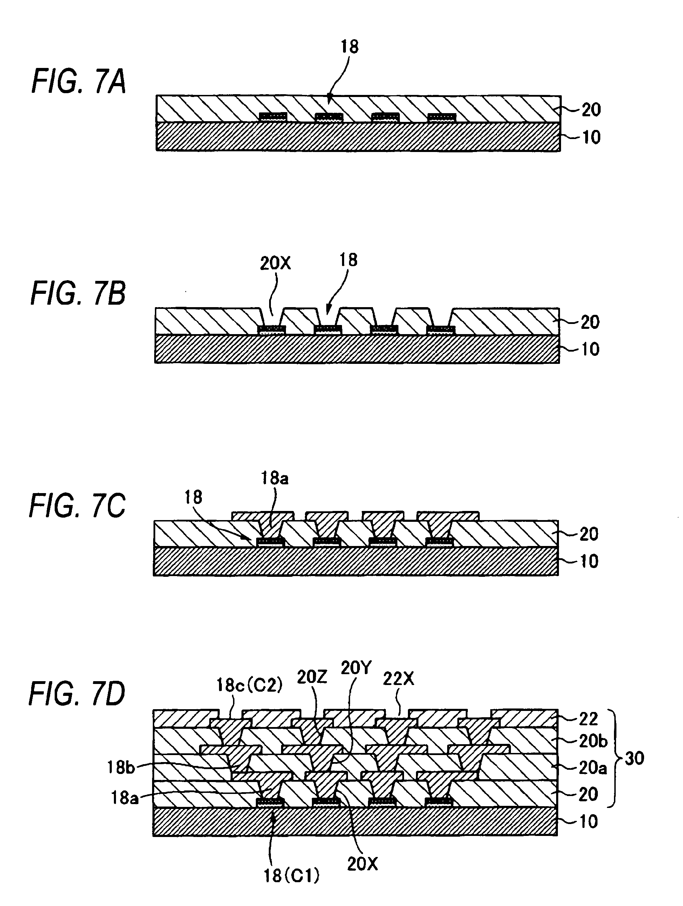

As described later, the reinforcing layer 50 is formed by etching a supporting body 10 (*see* FIG.7D). At this time, the opening portion 50X that exposes the surfaces of the first wiring layers 18 of the above wiring member 30 is also formed simultaneously.

The reinforcing layer 50 has a plurality of concave-convex portions 50a. The concave-convex strip portion 50a according to the present embodiment is formed into an almost trapezoidal shape when viewed as a sectional profile. Because the plurality of concave-convex portions 50a is formed on the reinforcing layer 50, the reinforcing layer 50 comes down in weight. Also, because the concave-convex portions 50a are provided in light of a stiffness performance of the wiring member 30, in which a stress is concentrated and which is easily deformed, stiffness of the wiring member 30 can be effectively ensured.

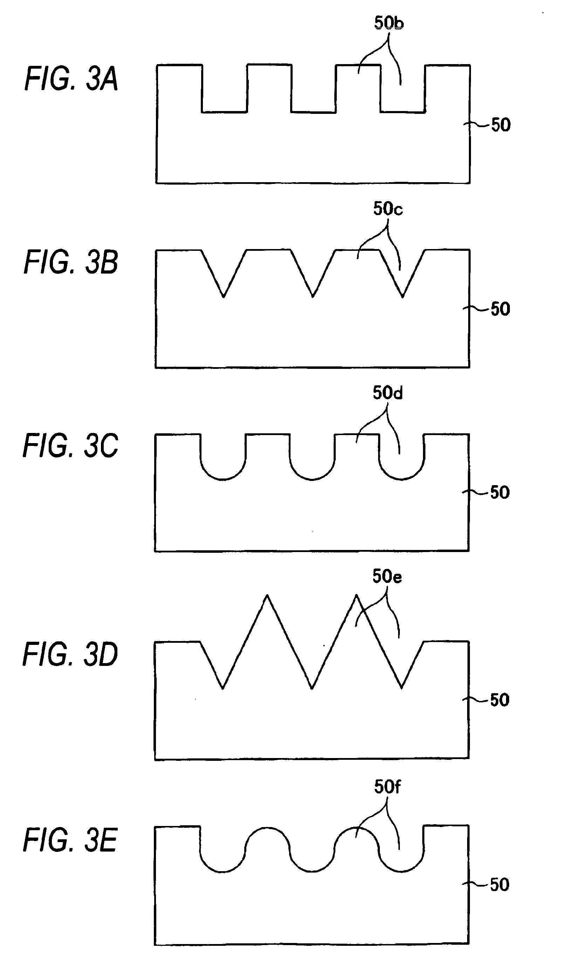

However, the sectional shape of the concave-convex strip portion is not limited to the above shape. For example, a rectangular concave-convex portion 50b shown in FIG.3A, a triangular concave-convex portion 50c shown in FIG.3B, a U-shaped concave-convex portion 50d shown in FIG.3C, a triangular concave-triangular convex portion 50e shown in FIG.3D, and a round wave concave-round wave convex portion 50f shown in FIG.3E may be employed as the sectional shape respectively.

Also, in the present embodiment, as shown in FIG.2B when viewed from the top, a plurality of concave-convex portions 50a are formed like the square frame as the reinforcing layer 50 respectively.

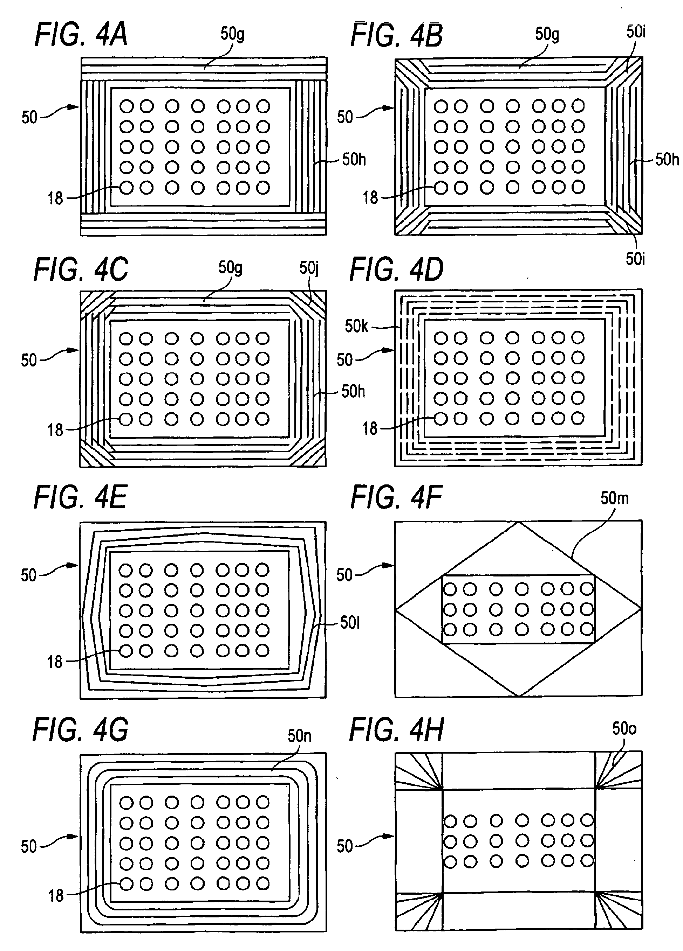

However, the planar shape of the concave-convex portion 50a is not limited to the above shape. For example, as shown in FIG.4A, the planar shape may be constructed by concave-convex portions 50g extending in the horizontal direction (the first direction) in FIG.4A, and concave-convex portions 50h extending in the vertical direction (second direction) in FIG.4A. Also, as shown in FIG.4B, a concave-convex portions 50i extending in the right-upward direction (the third direction) in FIG.4B at a corner portion of the reinforcing layer 50 may be formed and also, as shown in FIG.4C, concave-convex portions 50j extending in the right-downward direction (the fourth direction) in FIG.4C at a corner portion of the reinforcing layer 50 may be formed. In this case, for example, as shown in FIG.4B, the concave-convex portions 50g and the concave-convex portions 50i may be connected with each other at the corner portion to be bent there and, as shown in FIG.4C, six concave-convex portions 50h and four concave-convex portions 50j may be connected in combination at the corner portion to withstand a stress concentration at the corner portion.

Also, as shown in FIG.4D, concave-convex portions 50k formed like a square frame with slits may be constructed. As shown in FIG.4E, concave-convex portions 501 formed like a polygonal frame may be constructed. Also, as shown in FIG.4F, concave-convex portions 50m obtained by turning quadrangular shapes by 1/4 turn may be constructed. Also, as shown in FIG.4G, concave-convex portions 50n whose corner portions are rounded may be constructed. As shown in FIG.4H, concave-convex portions 50o formed to extend in the radial direction at the corner portion may be constructed. These shapes may be constructed on the portions where the stiffness of the wiring member 30 should be kept, as a combination of plural concave-convex portions.

In this manner, the concave-convex portions 50a formed on the reinforcing layer 50 are provided to exercise the strong stiffness in the direction along which the wiring member 30 is easily deformed. Therefore, deformation of the wiring member 30 can be prevented effectively. Also, the number and the layout of the connection pads 18 are not limited to the structure shown in FIG.2, and they can be set with a margin, as shown in FIGS.4A to 4H.

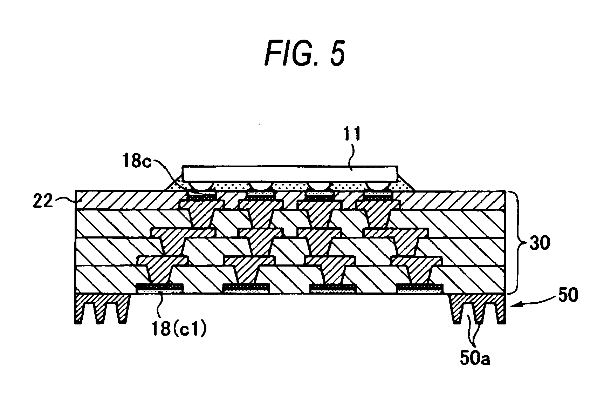

As shown in FIG.5, in the wiring substrate 1A, a semiconductor chip 11 can be mounted on the side on which the solder resist 22 of the wiring member 30 is formed, and external connection terminals can be connected to the connection pads 18 on the side on which the semiconductor element mounting surface is provided (wiring substrate 1B).

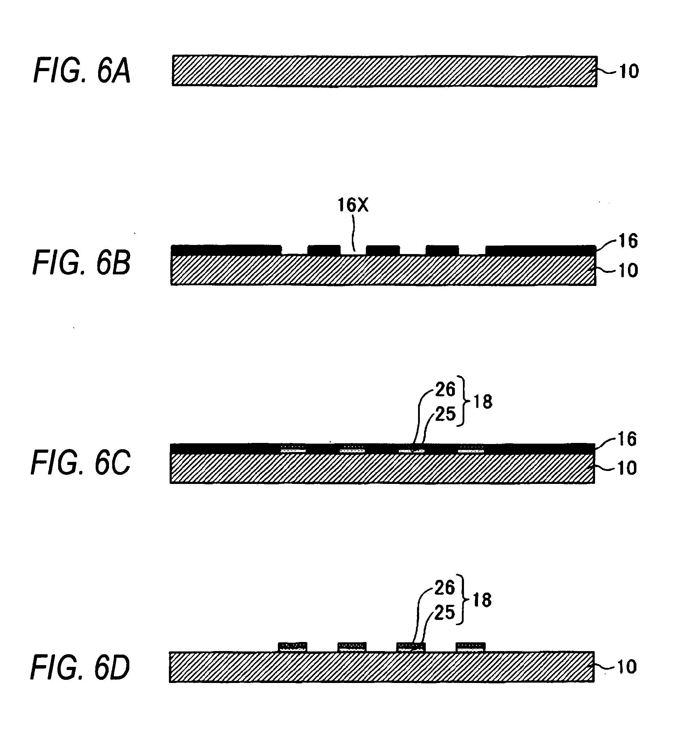

Next, a method of manufacturing the wiring substrate 1A according to the first embodiment will be described hereunder. FIGS.6 to 8 are cross-sectional views showing a method of manufacturing the wiring substrate 1A according to the first embodiment of the present invention.

In order to manufacture the wiring substrate 1A, as shown in FIG.6A, firstly, the supporting body 10 is prepared. In the present embodiment, a metal plate (e.g., Cu) or a metallic foil may be used as the supporting body 10. A resist film 16 is formed on the supporting body 10 by using a dry film, for example.

Then, as shown in FIG.6B, opening portions 16X are formed in predetermined portions (positions corresponding to forming positions of the connection pads 18 described later) by applying a patterning process to this resist film 16. In this case, the opening portions 16X may be formed in advance in the dry film-like resist film 16, and the resist film 16 having the opening portions 16X may be provided on the supporting body 10.

Then, as shown in FIG.6C, the connection pads 18 acting as the first wiring layers are formed on the supporting body 10 by the electroplating using the supporting body 10 as a plating power feeding layer. The connection pads 18 are formed in the opening portions 16X formed in the resist film 16. Each of the connection pads 18 includes a pad surface plating layer 25 and a pad main body 26.

The pad surface plating layer 25 has a structure that is obtained by forming an Au film, a Pd film, and a Ni film sequentially. Therefore, upon forming the connection pad 18, firstly, the pad surface plating layer 25 is formed by plating an Au film, a Pd film, and a Ni film sequentially, and then the pad main body 26 made of Cu is formed on this pad surface plating layer 25 by the plating.

In this manner, the connection pads 18 are formed. Then, as shown in FIG.6D, the resist film 16 is removed. In this case, the connection pads 18 function as the first connection terminals C1.

Then, as shown in FIG.7A, the first insulating layer 20 for covering the connection pads 18 is formed on the supporting body 10. As the first insulating layer 20, a resin material such as an epoxy resin or a polyimide resin may be used. As one example of the method of forming the first insulating layer 20, a resin film is laminated on the supporting body 10, and then the resin film is cured by applying a heat treatment at a temperature of 130 to 150 °C while pressing the resin film, whereby the first insulating layer 20 can be obtained.

Then, as shown in FIG.7B, first via holes 20X are formed by the laser beam machining such that the connection pads 18 are exposed from the first insulating layer 20 that is formed on the supporting body 10. In this case, the first insulating layer 20 may be formed by patterning a photosensitive resin film using photolithography technique, or may be formed by patterning the resin film having the openings using the screen printing technique.

Then, as shown in FIG.7C, the second wiring layers 18a connected to the connection pads 18 (constituting the first wiring layers) formed on the supporting body 10 via the first via holes 20X are formed. The second wiring layers 18a may be formed of copper (Cu), and formed on the first insulating layer 20. The second wiring layers 18a are formed by the semi-additive process, for example.

As an example of method of forming the second wiring layers 18a, firstly, a Cu seed layer (not shown) is formed in the first via holes 20X and on the first insulating layer 20 by the electroless plating or the sputtering technique. Then, a resist film (not shown) having openings corresponding to the second wiring layers 18a is formed. Then, Cu layers patterns (not shown) are formed in the openings in the resist film respectively by the electroplating using the Cu seed layer as a plating power feeding layer.

After that, the resist film is removed. Finally, the second wiring layers 18a are formed by etching the Cu seed layer while using the Cu layer patterns as a mask. In this case, as the method of forming the second wiring layers 18a, various wiring forming methods such as the subtractive process can be employed in addition to the above semi-additive process.

Then, as shown in FIG.7D, the second insulating layer 20a for covering the second wiring layers 18a is formed on the supporting body 10 by repeatedly performing the similar steps, and then second via holes 20Y are formed in portions of the second insulating layer 20a on the second wiring layers 18a. Then, the third wiring layers 18b connected to the second wiring layers 18a via the second via holes 20Y are formed on the second insulating layer 20a of the supporting body 10.

Then, the third insulating layer 20b for covering the third wiring layers 18b is formed on the supporting body 10, and then third via hole 20Z are formed in portions of the third insulating layer 20b on the third wiring layers 18b. Then, the fourth wiring layers 18c connected to the third wiring layers 18b via the third via hole 20Z are formed on the third insulating layer 20b of the supporting body 10.

Then, the solder resist film 22 in which the opening portions 22X are provided is formed on the fourth wiring layers 18c of the supporting body 10. Accordingly, the fourth wiring layers 18c exposed from the opening portions 22X in the solder resist film 22 act as the second connection terminals C2.

In this manner, a desired build-up wiring layer is formed on the connection pads (the first connection terminals C1) on the supporting body 10. In the above example, the four-layered build-up wiring layer (first to fourth wiring layers 18 to 18c) is formed. But the n (n is an integral number in excess of 1)-layered build-up wiring layer may be formed.

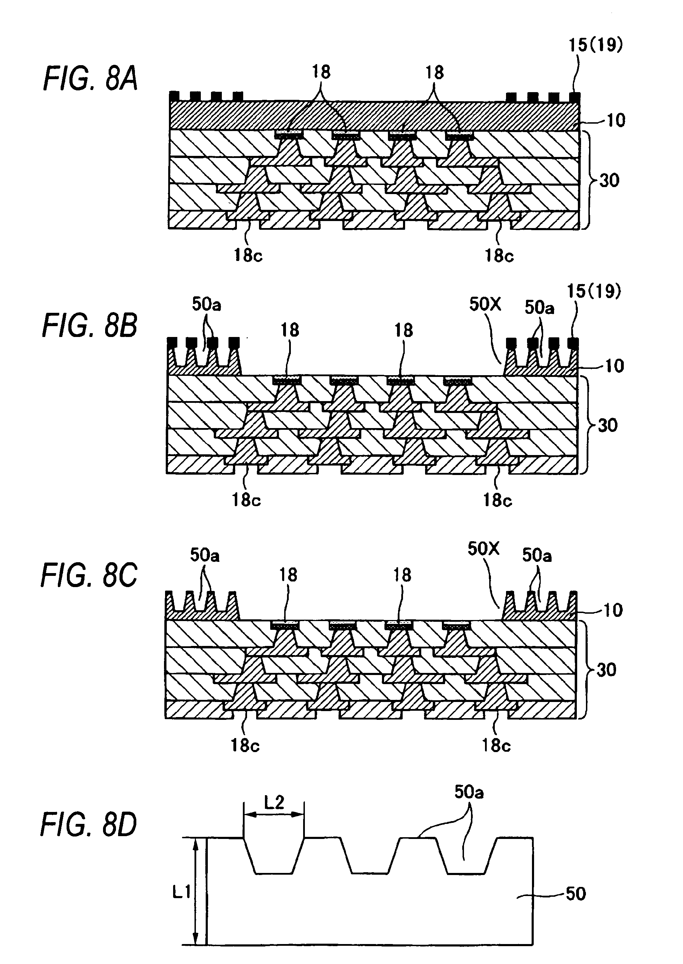

Then, as shown in FIG.8A, a resist film 15 having patterns that correspond to the above concave-convex portions 50a is formed on the supporting body 10 acting as the supporting body. As shown in FIG.8B, the etching is applied using the resist film 15 as a mask. According to this etching, the opening portion 50X is formed in the supporting body 10, and also the concave-convex portions 50a corresponding to the patterns in the resist 15 are formed on the supporting body remaining like the frame (referred to as the "reinforcing layer 50" hereinafter). In the present embodiment, the opening portion 50X and the concave-convex portions 50a may be formed at the same time by this etching process.

Then, as shown in FIG.8C, the reinforcing layer 50 on which the concave-convex portions 50a are formed is formed by peeling off the resist. Then, as shown in FIG.8D, when a thickness L1 of the reinforcing layer 50 is set to 100 µm ≤ L1 ≤ 1000 µm, a process width L2 can be set to 30 µm ≤ L2 ≤ 500 µm.

In the wiring substrate 1A formed in this manner, the stiffness (shape stiffness) can be enhanced by the reinforcing layer 50 having a plurality of concave-convex portions 50a, and the concave-convex portions 50a can be formed in the direction where the deformation of the wiring substrate can be withstood. As a result, the deformation can be prevented more effectively.

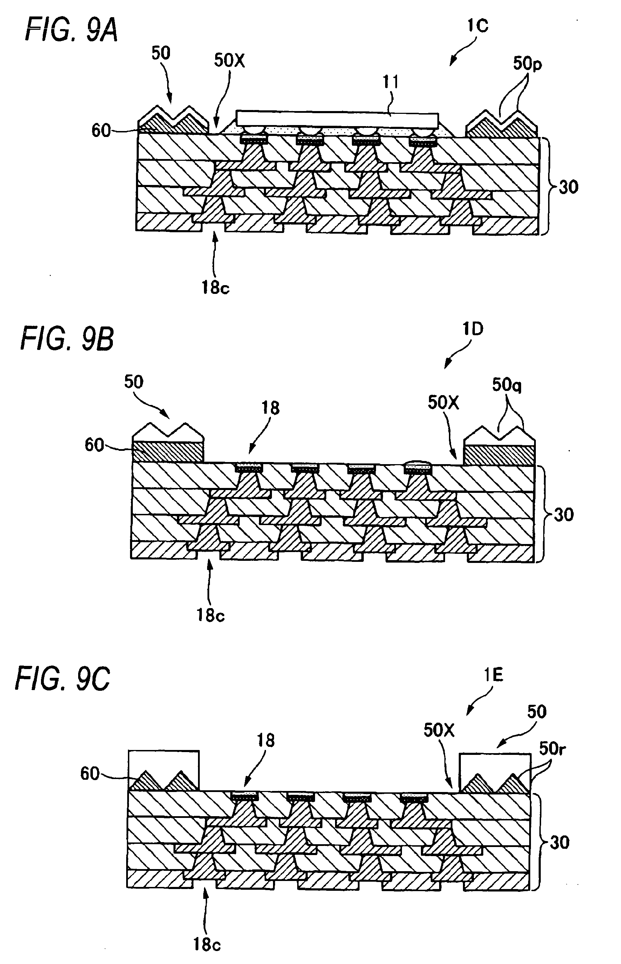

Next, a wiring substrate according to a second embodiment of the present invention will be described hereunder. FIG.9A is a cross-sectional view showing a wiring substrate 1C according to the second embodiment, and FIGS.9B and 9C show a variation of the wiring substrate 1C respectively.

As shown in FIG.9A, in the wiring substrate 1C according to the second embodiment, an adhesive member 60 is coated around the first wiring layers 18 of the wiring member 30, and then the reinforcing layer 50 having a plurality of concave-convex portions 50p is provided onto the adhesive member 60.

In the reinforcing layer 50 of the wiring substrate 1C, a plurality of concave-convex portions 50p are formed in advance on a metal (copper, aluminum, or the like), a glass, a ceramic, a rigid resin, or a copper-clad laminate (whose FR grade is FR-4), for example, by the process apart from the steps of manufacturing the wiring member. The concave-convex portions 50p are formed by bending the plate member like crests and valleys.

The shape of the concave-convex portions 50p of the reinforcing layer 50 may be constructed as shown in FIGS.4A to 4H, in addition to FIGS.3A to 3E. Further, as shown in FIG.9B, the concave-convex portions may be formed on the main body formed as a block. In FIG.9B, concave-convex portions 50q are provided on a wiring substrate 1D. As shown in FIG.9C, crest and valley shapes may be formed to face the surface of the wiring member 30, when viewed from a cross-sectional profile. In FIG.9C, concave-convex portions 50r are provided to face the surface of a wiring substrate 1E.

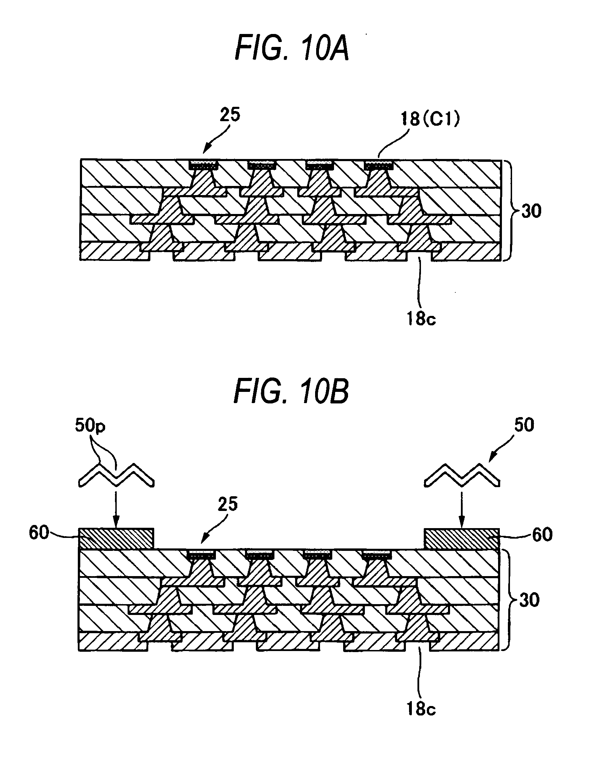

Next, a method of manufacturing the wiring substrate 1C according to the second embodiment will be described hereunder. FIGS.10A and 10B are views showing a method of manufacturing the wiring substrate 1C according to the second embodiment. In this case, the same reference symbols are affixed to the configurations corresponding to the configurations shown in FIGS.6A to 7D, and their description will be omitted herein.

In the wiring substrate 1C according to the present embodiment, the wiring member 30 is formed on the supporting body 10 by the same manufacturing method as that of the wiring substrate 1A according to the first embodiment of the present invention and the steps are the same as those shown in FIG.6A to 7D.

As shown in FIG.10A, the supporting body 10 acting as the supporting body is removed. The supporting body 10 may be removed by the wet etching using an iron (III) chloride aqueous solution, a copper (II) chloride aqueous solution, an ammonium peroxodisulfate aqueous solution, or the like.

In this manner, the supporting body 10 is removed. Then, as shown in FIG.10B, the wiring member 30 and the reinforcing layer 50 are bonded to each other. A thermosetting adhesive 60 is used in the bonding process. The thermosetting adhesive 60 is not limited to the thermosetting type adhesive, and various adhesives such as an ultraviolet curable type adhesive may be employed.

The reinforcing layer 50 of the wiring substrate 1C according to the present embodiment can be formed through the manufacturing steps that are performed separately from the manufacturing steps of the wiring member 30. For example, when the metal plate is used, the reinforcing layer 50 having the concave-convex portions 50p can be obtained by applying the press working to the metal plate.

Because the concave-convex portions 50p are provided, the reinforcing layer 50 of the wiring substrate 1C formed through the above processes can be reduced in weight as compared with the related art, and further the stiffness (shape stiffness) of the reinforcing layer 50 can be enhanced.

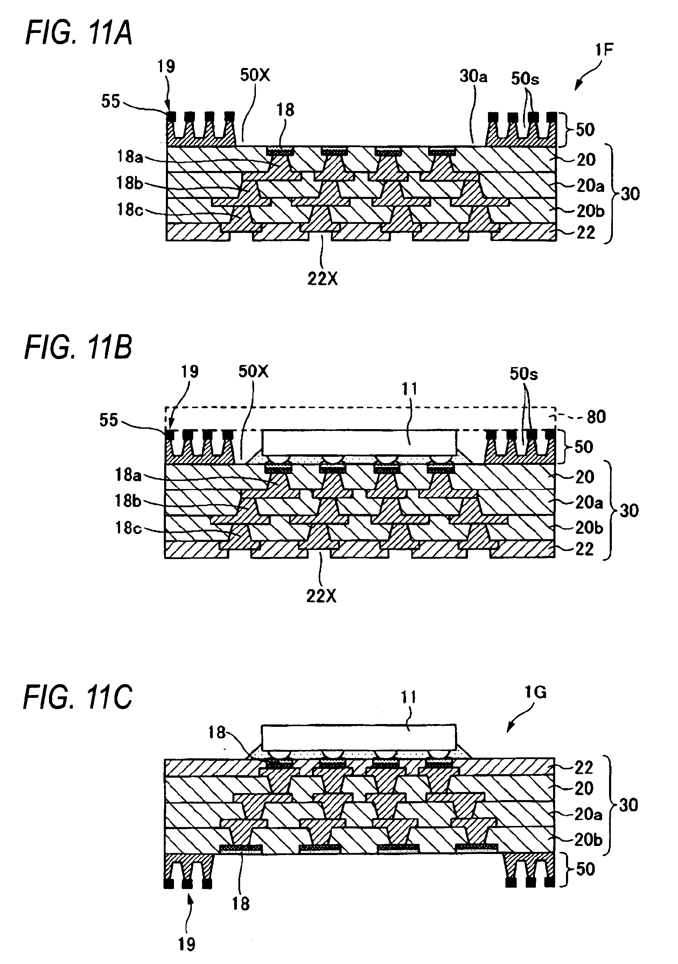

Next, a wiring substrate 1F according to a third embodiment of the present invention will be described hereunder. FIG.11A is a cross-sectional view of the wiring substrate 1F, and FIG.11B is a cross-sectional view of the wiring substrate 1F on which a semiconductor element and a heat spreader (indicated with a broken line in FIG.11B) are mounted.

Like the wiring substrate 1A of the first embodiment, the wiring substrate 1F according to the present embodiment, if roughly classified, is constructed by the wiring member 30 and the reinforcing layer 50. The wiring member 30 is formed by layering the insulating layers 20 to 20b and the wiring layers 18 to 18c, and the connection pads 18 are exposed from the surface 30a of the wiring member 30. The solder resist 22 having the opening portions 22X is formed on the back surface of the wiring member 30, and the fourth wiring layer 18c is exposed from the opening portions 22X.

The opening portion 50X is formed in the reinforcing layer 50, and the connection pads 18 on the wiring member 30 are exposed from the opening portion 50X. Also, the reinforcing layer 50 has a plurality of concave-convex portions 50s. In this present embodiment, a nickel layer 19 is provided on convex top end portions 55 of the concave-convex portions 50s respectively. Thus, such a double-layered structure is employed that the nickel layer 19 is provided on the concave-convex portions 50s of the reinforcing layer 50 formed of copper. Therefore, the stiffness of the reinforcing layer 50 can be further improved because a stiffness of the nickel is higher than the copper.

Also, FIG.11B is a view showing a state that a heat spreader 80 connected thermally to the semiconductor element 11 is provided on the reinforcing layer 50. In order to enhance heat radiation efficiency of a heat radiated from the semiconductor element 11, it is advantageous that the heat spreader 80 should be adhered to the back surface of the semiconductor element 11 by an adhesive or a solder. In the present embodiment, since the nickel layers 19 are provided between the heat spreader 80 and the reinforcing layer 50, the reinforcing layer 50 can achieve such an advantage that the heat spreader 80 is not press-contacted to the semiconductor element 11. Also, adhesion of the nickel to the adhesive or the solder is higher than the copper. Therefore, since the nickel layer 19 is provided to the convex top end portions 55 respectively, the heat spreader 80 can be adhered more strongly onto the concave-convex portions 50s.

Here, the concave-convex portions 50s according to the present embodiment are constructed to have an almost trapezoidal shape when viewed from a cross-sectional profile. But the concave-convex portions 50s may be constructed like FIGS.4A to 4H in addition to above FIGS.3A to 3E.

Also, a wiring substrate 1G shown in FIG.11C is constructed such that, in the above wiring substrate 1F, the semiconductor chip 11 is mounted on the side on which the solder resist 22 of the wiring member 30 is formed, and the external connection terminals are connected to the connection pads 18 in the semiconductor element mounting surface side. In this configuration, the similar advantages to the above wiring substrate 1F can also be achieved.

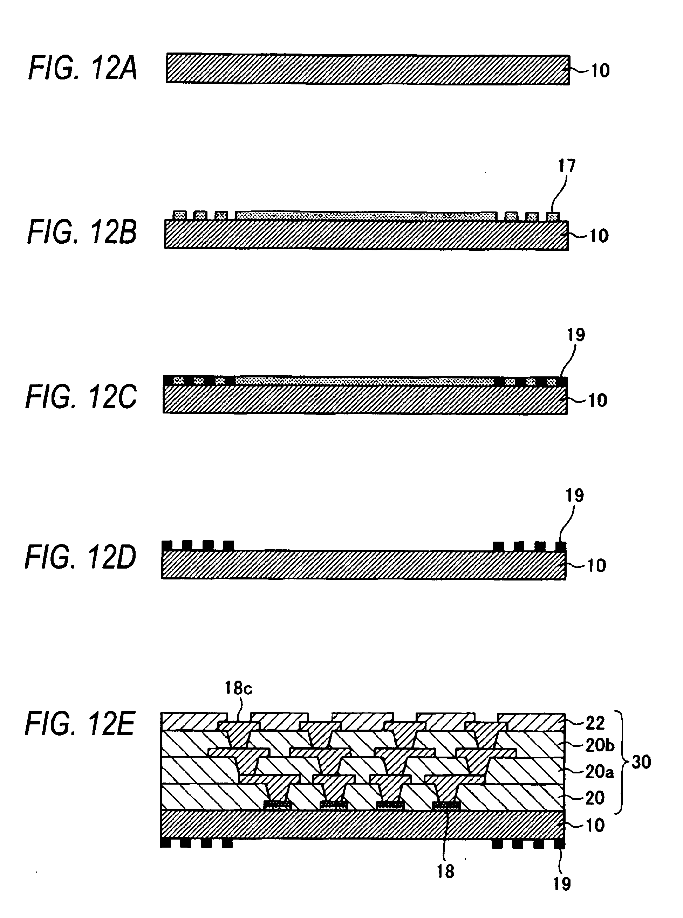

Next, a method of manufacturing the wiring substrate 1F according to the above third embodiment will be described hereunder. FIGS.12A to 12E are cross-sectional views showing the method of manufacturing the wiring substrate 1F according to the third embodiment. Here, the same reference symbols are affixed to the configuration corresponding to the configuration shown in FIG. 6A to 7D, and their description will be omitted herein.

In order to manufacture the wiring substrate 1F, as shown in FIG.12A, firstly, the same supporting body 10 as that used in the first embodiment is prepared. Then, as shown in FIG.12B, a resist film 17 having the patterns corresponding to the concave-convex portions 50s is formed on the supporting body 10, and then patterning process is performed.

Then, as shown in FIG.12C, a nickel is plated while using the supporting body 10 as a power feeding layer. Then, as shown in FIG.12D, the nickel layer 19 serving as a mask that is used to form the opening portion 50X and the concave-convex portions 50s is formed on the supporting body 10 by removing the plating resist 17.

Then, the wiring member 30 is formed on a back surface opposite to the surface of the supporting body 10 on which the nickel layer 19 is formed, by the manufacturing steps similar to those in the first embodiment shown in FIGS.6A to 7D (*see* FIG.12E).

Then, a plurality of concave-convex portions 50s and the reinforcing layer 50 are formed in the steps shown in FIGS.8A and 8B. In the manufacturing method in the first embodiment, in order to form the reinforcing layer 50 having the concave-convex portions, the resist film 15 used to etch the supporting body 10 is formed on the supporting body 10 shown in FIG.8A. In contrast, in the manufacturing method in the present embodiment, the nickel layer 19 has already been formed in the first stage shown in FIG.12. Therefore, in the present embodiment, the supporting body 10 is etched using the nickel layer 19 in FIG.8B as a mask. As a result, the opening portion 50X in the reinforcing layer 50 can be formed while the reinforcing layer 50 having the concave-convex portions 50s is formed.

## Claims

1. A wiring substrate (1A; 1C; 1F), comprising:
a wiring member (30) formed by at least one layering insulating layer and at least one wiring layer, the wiring member (30) comprising at least one connection pad (18) thereon; and
a reinforcing layer (50) which is provided on the wiring member (30) to surround the at least one connection pad (18) and which comprises a plurality of concave-convex portions (50a) thereon.

2. The wiring substrate according to claim **1,** wherein the concave-convex portions (50a) are provided to extend in plural different directions.

3. The wiring substrate according to any of the preceding claims, wherein the reinforcing layer is formed of copper, and a nickel layer is provided on convex top end portions of the concave-convex portions (50a).

4. A semiconductor device comprising:
the wiring substrate (1A; 1C; 1F) according to claim **1;**
a semiconductor element (11) mounted on the wiring substrate (1A; 1C; 1F); and
a heat spreader (80) provided on the semiconductor element (11).

5. A method of manufacturing a wiring substrate (1A; 1C; 1F), the method comprising:
(a) layering at least one insulating layer and at least one wiring layer on a supporting body to form a wiring member (30);
(b) removing a part of the supporting body from the wiring member (30) to form an opening through which an outermost surface of the at least one wiring layer is exposed; and
(c) patterning a reinforcing layer (50) to form a plurality of concave-convex portions (50a) in the reinforcing layer (50).

6. A method of manufacturing a wiring substrate (1A; 1C; 1F), the method comprising:
(a) layering at least one insulating layer and at least one wiring layer on a supporting body to form a wiring member (30);
(b) removing the supporting body from the wiring member (30); and
(c) providing a reinforcing layer (50) having a plurality of concave-convex portions (50a) thereon on the wiring member (30) via an adhesive.
